Europäisches Patentamt

European Patent Office

Office européen des brevets

(19)

(11) Veröffentlichungsnummer: **0 026 442**
A1

# (12) EUROPÄISCHE PATENTANMELDUNG

(21) Anmeldenummer: 80105730.8

(22) Anmeldetag: 24.09.80

(51) Int. Cl.³: **H 03 B 1/04**
**H 03 K 21/00**

(30) Priorität: 27.09.79 DE 2939079

(43) Veröffentlichungstag der Anmeldung:
08.04.81 Patentblatt 81/14

(84) Benannte Vertragsstaaten:
CH FR GB LI

(71) Anmelder: Rohde & Schwarz GmbH & Co. KG
Mühldorfstrasse 15
D-8000 München 80(DE)

(72) Erfinder: Frühauf, Tonio
Fasanenstrasse 68
D-8025 Unterhaching(DE)

(72) Erfinder: Löffler, Heinrich
Bad Dürkheimerstrasse 26
D-8000 München 90(DE)

(72) Erfinder: Richter, Josef
Fasanenweg 14
D-8013 Haar(DE)

(74) Vertreter: Graf, Walter
Sckellstrasse 1
D-8000 München 80(DE)

(54) Schaltungsanordnung zum Erzeugen einer rauscharmen Hochfrequenzausgangsschwingung.

(57) Zum Erzeugen einer möglichst rauscharmen Hochfrequenz-Ausgangsschwingung (A) mittels eines eine Ursprungsschwingung (0) höherer Frequenz erzeugenden Oszillators (1) und eines diese Ursprungsschwingung in der Frequenz herabteilenden Frequenzteilers (2) wird mit dem in der Frequenz herabgeteilten Ausgangssignal (U) des Frequenzteilers (2) ein elektronischer Schalter (3) gesteuert, der zwischen Oszillator (1) und Ausgang (12) angeordnet ist und mit dem unmittelbar aus der Ursprungsschwingung (0) des Oszillators (1) die in der Frequenz niedrigere Ausgangsschwingung (A) ausgeblendet wird.

EP 0 026 442 A1

./...

# Patentanwalt Dipl.-Ing. Walter Graf

**0026442**

D-8000 München 80
Sckellstraße 1
Telefon (089) 4 48 08 67
Telex 523703 (rus d)
Postscheck München 182826-804
Hypo-Bank München 3860043210
Deutsche Bank München 53103797

zugelassen beim Europäischen Patentamt – admitted to the European Patent Office – Mandataire agréé auprès l' Office Européen des Brevets

964-P

- 1 -

## Schaltungsanordnung zum Erzeugen einer rauscharmen Hochfrequenzausgangsschwingung

Die Erfindung betrifft eine Schaltungsanordnung laut Oberbegriff des Hauptanspruches.

Zum Erzeugen von möglichst rauscharmen Hochfrequenz-Ausgangsschwingungen ist es bekannt, einen auf einer relativ hohen Ursprungsfrequenz schwingenden Oszillator, beispielsweise einen Sinuswellenoszillator von bereits relativ guten Phasenrauscheigenschaften, vorzusehen und dessen Ursprungsschwingung mit einem nachgeschalteten Frequenzteiler in der Frequenz auf die gewünschte Ausgangsschwingung herabzuteilen. Hochfrequenzoszillatoren können nämlich bekanntlich in höheren Frequenzlagen mit besseren Rauscheigenschaften hergestellt werden als für niedrigere Ausgangsfrequenzen. Der nachgeschaltete Frequenzteiler besitzt den Vorteil, dass auch die Rauscheigenschaften der Ursprungsschwingung um den Frequenzteilungsfaktor verringert werden, die durch Frequenzteilung erzielte Ausgangsschwingung also noch weniger Rauschen aufweist als die schon sehr rauscharme Ursprungsschwingung des Oszillators. Dieser theoreti-Vorteil wird in der Praxis jedoch dadurch eingeschränkt, dass die bisher üblichen Frequenzteiler je nach Aufbau mehr oder weniger Eigenrauschen besitzen, um welches die Rauscheigenschaften der Ursprungsschwingung bei der Frequenzteilung wieder entsprechend verschlechtert werden.

Es ist Aufgabe der Erfindung, eine Schaltungsanordnung dieser Art so weiterzubilden und zu verbessern, dass die Ausgangsschwingung möglichst geringes Phasenrauschen besitzt.

Diese Aufgabe wird ausgehend von einer Schaltungsanordnung laut Oberbegriff des Hauptanspruches durch dessen kennzeichnende Merkmale gelöst. Vorteilhafte Weiterbildungen ergeben sich aus den Unteransprüchen.

Bei der erfindungsgemässen Schaltungsanordnung wird nicht das über den Frequenzteiler mit verschlechterten Rauscheigenschaften erzeugte Signal zur Bildung der gewünschten Ausgangsschwingung benutzt sondern damit wird nur ein am Ausgang der Frequenzquelle zwischengeschalteter Schalter angesteuert, mit dem damit unmittelbar aus der Ursprungsschwingung eine in der Frequenz entsprechend herabgeteilte Ausgangsschwingung ausgeblendet wird. Durch diesen Ausblendvorgang wird die Kurvenform der Ursprungsschwingung, also zumindest die Anstiegsflanke der Ursprungs-Sinusschwingung, nicht beeinflusst, die aus dem Ursprungssignal ausgeblendeten Schwingungszüge behalten also ihre Ursprungsform und es wird damit kein zusätzliches Rauschen eingeführt. Damit besitzt die am Ausgang der Schaltung auftretende Ausgangsschwingung Rauscheigenschaften, die um den Teilungsfaktor des Frequenzteilers gegenüber der Ursprungsschwingung verbessert sind, ohne dass diese Verbesserung durch Eigenrauschen der Schaltung verschlechtert ist, denn das Ursprungssignal durchläuft keine zusätzliches Eigenrauschen erzeugende Schaltungsteile sondern nur einen elektronischen Schalter, der mit modernen Bauelementen mit extrem geringen Rauscheigenschaften aufgebaut werden kann. Mit einer erfindungsgemässen Schaltungsanordnung können mit einfachen Mitteln erstmals extrem rauscharme Hochfrequenz-Ausgangsschwingungen erzeugt werden, wie dies mit dieser Güte bisher nicht möglich war. Eine erfindungsgemässe Schaltungsanordnung ist daher besonders geeignet zum Aufbau von Frequenzsyntheseschaltungen, bei denen mit solchen hochstabilen Ausgangsschwingungen durch weitere Frequenzvervielfachungs- bzw. Frequenzteilungsvorgänge Ausgangssignale beliebiger Frequenz erzeugt werden, die damit ebenfalls extrem gute Rauscheigenschaften besitzen.

Es sind an sich schon digitale Frequenzteiler bekannt, bei denen die in der Frequenz zu teilende Ursprungs-Impulsfolge dem einen Eingang einer Und-Schaltung zugeführt wird, deren anderer Eingang mit dem Ausgangssignal eines Frequenzteilers angesteuert wird (z.B. DE-OS 26 54 955 bzw. US-PS 39 25 764). Am Ausgang der Und-Schaltung entsteht damit eine um den Teilungsfaktor des Frequenzteilers herabgeteilte Ausgangs-Impulsfolge, die jedoch nicht im eigentlichen Sinne aus der Ursprungs-Impulsfolge durch Ausblenden gewonnen ist. Eine solche bekannte digital arbeitende Schaltungsanordnung wäre für den erfindungsgemässen Zweck nicht geeignet, da am Ausgang der Und-Schaltung kein Signal mit der gleichen Kurvenform wie das Ursprungssignal erreicht wird. Dies wird erst durch die erfindungsgemässe analoge Lösung mit einem in die Ausgangsleitung eingeschalteten elektronischen Schalter möglich, der die eingangsseitig angebotene Ursprungsschwingung ohne Beeinflussung ihrer Kurvenform im geschlossenen Zustand zum Ausgang durchschaltet.

Die erfindungsgemässe Schaltungsanordnung ist besonders vorteilhaft zum Erzeugen von sinusförmigen Ausgangsschwingungen, und zwar abgeleitet von einem besonders einfach mit guten Rauscheigenschaften aufgebauten Sinuswellen-Ursprungsoszillator. U.u. kann die erfindungsgemässe Massnahme jedoch auch von Vorteil sein zum Erzeugen von besonders rauscharmen Ausgangsschwingungen anderer Kurvenform, beispielsweise von Rechteck- oder Sägezahnform.

Die Erfindung wird im folgenden anhand einer schematischen Zeichnung an einem Ausführungsbeispiel näher erläutert.

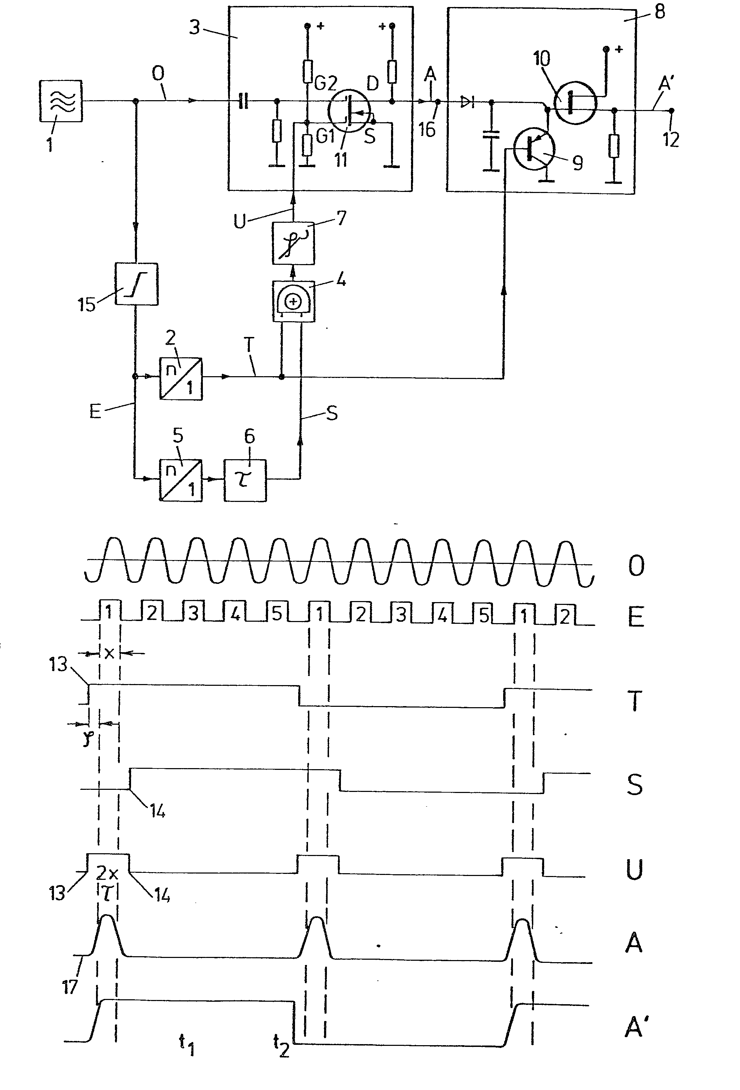

Die Figur zeigt das Prinzipschaltbild einer erfindungsgemässen Schaltungsanordnung. Eine Hochfrequenzquelle 1 erzeugt eine Sinus-Ursprungsschwingung 0 von relativ guter Reinheit, d.h. durch bekannte Massnahmen besitzt diese Ursprungsschwingung möglichst geringes Phasenrauschen. Die Ursprungsschwingung 0 wird über einen Impulsformer 15 zu einer Impulsfolge E umgewandelt, die über einen Frequenzteiler 2 mit einem vorzugsweise einstellbaren Teilungsfaktor n in der Frequenz um den Faktor n herabgeteilt wird. Das am Ausgang des Frequenzteilers 2 entstehende in der Frequenz herabgeteilte Ausgangssignal T wird dem einen Eingang einer logischen Schaltung 4, beispielsweise einer Exklusiv-Oder-Schaltung, zugeführt. Dem anderen Eingang dieser logischen Schaltung 4 wird ein in der Phase um die Periodendauer 2x gegenüber dem Signal T verschobenes Steuersignal S der gleichen Frequenz wie das Signal T zugeführt. Dieses zusätzliche Signal S wird ebenfalls vom Ursprungssignal E abgeleitet, und zwar entweder im Sinne des Ausführungsbeispiels durch einen zusätzlichen Frequenzteiler 5 mit dem Teilungsfaktor n oder unmittelbar aus dem invertierten Ausgang des Frequenzteilers 2. Die gewünschte Phasenverschiebung 2x wird durch die zwischengeschaltete Verzögerungsschaltung 6 erreicht. Am Ausgang der logischen Schaltung 4 entsteht damit eine Impulsfolge, die nach Durchlaufen des nachgeschalteten Phasenschiebers 7 der Impulsfolge U entspricht. Mit diesen Impulsen U wird ein elektronischer Schalter 3 angesteuert, dem eingangsseitig die Ursprungsschwingung O zugeführt wird und durch den damit aus der Ursprungsschwingung O die in der Frequenz herabgeteilte Ausgangsschwingung A ausgeblendet wird. Mit dem Phasenschieber 7 werden die Ausblendimpulse U an die Ursprungsschwingung O angepasst, d.h. über diesen Phasenschieber 7 wird der Beginn 13 der Ausblendimpulse U, der ja bestimmt ist durch den Beginn der Ausgangsimpulse T des Frequenzteilers 2, so gelegt, dass er gerade am Scheitel der unteren Halbwelle der Ursprungs-Sinusschwingung O zu liegen kommt. Das Ende 14 der Ausblendimpulse U liegt wegen der gerade einer Periodendauer entsprechenden Impulsdauer damit am Scheitel der nächstfolgenden unteren Halbwelle der Ursprungsschwingung O und es wird damit am Ausgang 16 des elektronischen Schalters 3 während der Schliesszeit 2x der Ausblendimpulse U die Ausgangsschwingung A aus der Ursprungsschwingung O ausgeblendet. Die Figur zeigt, dass die aus dem Ursprungssignal O ausgeblendeten Sinushalbwellen des Ausgangssignales A in ihrer Kurvenform völlig unbeeinflusst bleiben, d.h. sowohl Anstiegsflanke der Sinushalbwelle als auch Abfallflanke dieser Schwingung bleiben unbeeinflusst. Selbst wenn die Impulszüge T, S und U infolge der zwischengeschalteten Schaltungsteile wie Frequenzteiler zusätzliches Eigenrauschen besitzen, was sich durch nicht genau definierte Lage des Beginns 13 bzw. des Endes 14 der Ausblendimpulse zeigt (die Impulse besitzen dadurch sogenannten Jitter), so wird trotzdem hierdurch die Kurvenform nicht beeinflusst, also kein zusätzliches Eigenrauschen in die Ausgangsschwingung A mit eingebracht.

Der Phasenschieber 7 kann im Prinzip an jeder beliebigen Stelle innerhalb der Schaltungsanordnung eingebaut sein, es muss mit ihm nur die relative Phasenbeziehung zwischen dem Ursprungssignal O und den davon abgeleiteten Ausblendimpulsen U einstellbar sein.

Der elektronische Schalter 3 kann von beliebiger Bauart sein, er muss nur eine die Ursprungsschwingung O unverändert zum Ausgang 16 übertragende Schaltstrecke besitzen, die selbst möglich geringes Eigenrauschen besitzt, und er muss über die Ausblendimpulse U ansteuerbar sein. Eine besonders einfache und vorteilhafte Ausbildung für diesen elektronischen Schalter 3 ergibt sich, wenn im Sinne des Ausführungsbeispieles hierzu ein Doppelgate-Feldeffekttransistor 11 verwendet wird, dessen erste Steuerstrecke zwischen dem einen Gate g2 und dem Draine d als Schaltstrecke für die Ursprungsschwingung dient und dessen andere Steuerstrecke zwischen Gate g1 und Source s mit den Ausblendimpulsen U angesteuert wird. Eine solche Schaltung eines als Verstärkungselement wirkenden Doppelgate-Feldeffekttransistors 11 besitzt besonders günstige Rauscheigenschaften und vor allem auch besonders gut gegeneinander entkoppelte Steuerstrecken und Steuereingänge. Sie besitzt ferner den Vorteil, dass automatisch immer beginnend mit dem Scheitel 17 der unteren Halbwelle der Ursprungs-Sinusschwingung die Schaltstrecke geschlossen wird, also die für die Ausgangsschwingung A gewünschten Ein- und Ausschaltzeitpunkte auch bei mit Jitter behafteten Ausblendimpulsen U eingehalten werden.

Die Ausgangsschwingung A besitzt je nach dem Teilungsfaktor n des Frequenzteilers ein mehr oder weniger unsymmetrisches Tastverhältnis, in dem gezeigten Ausführungsbeispiel mit einem Teilungsfaktor n = 5 also ein Tastverhältnis von 1:5. Nachdem in den meisten Anwendungsfällen jedoch eine Ausgangsschwingung mit der geteilten Frequenz gewünscht wird, die ein Tastverhältnis von 1:1 besitzt, aus der dann in bekannter Weise beispielsweise wieder eine Sinusschwingung abgeleitet werden kann, ist am Ausgang des elektronischen Schalters 3 noch eine Halteschaltung 8 vorgesehen, die in einem Speicherkondensator noch in den Lücken zwischen den aufeinanderfolgenden Halbwellen der Ausgangsschwingung A die jeweils zugeführte Spannung speichert. Über den zusätzlichen elektronischen Schalter 9, der vom Ausgangssignal T des Frequenzteilers 2 angesteuert ist, wird erreicht, dass der Speicherkondensator erst wieder am Ende des Schaltimpulses T entladen wird. Am Ausgang des als Trennstufe dienenden Emitterfolgers 10 entsteht damit eine Ausgangsschwingung A', die die gleiche Frequenz wie die Schwingung A besitzt, jedoch ein Tastverhältnis von 1:1 und deren Anstiegsflanken jeweils den unverfälschten Flanken des ursprünglichen Sinussignales entsprechen. Damit kann dann in bekannter Weise sehr einfach ein entsprechendes vollständiges Sinussignal abgeleitet werden, das extrem rauscharm ist, da zu seiner Erzeugung ja die unverfälschten Anstiegsflanken der Ursprungs-Sinusschwingung verwendet werden.

Im Ausführungsbeispiel ist das Ausblenden einer vollen Periode der Ursprungsschwingung dargestellt. In manchen Fällen kann es ausreichen, nur die Vorderflanke der Sinusschwingung unverformt aus der Ursprungsschwingung auszublenden. Die Phasenverschiebung mittels des Phasenschiebers 7 muss dann auf die halbe Periodendauer eingestellt werden, ebenso die Dauer der Ausblendimpulse U.

# Patentanwalt Dipl.-Ing. Walter Graf

D-8000 München 80
Sckellstraße 1
Telefon (089) 4 48 08 67
Telex 523703 (rus d)
Postscheck München 182826-804
Hypo-Bank München 3860 043 210
Deutsche Bank München 53103 797

zugelassen beim Europäischen Patentamt – admitted to the European Patent Office – Mandataire aggréé auprès l' Office Européen des Brevets

964-P

ROHDE & SCHWARZ GmbH & Co, KGm   8000 München 80

Patentansprüche

1. Schaltungsanordnung zum Erzeugen einer rauscharmen Hochfrequenz-Ausgangsschwingung mit einer eine Ursprungsschwingung höherer Frequenz erzeugenden Frequenzquelle und einem diese Ursprungsschwingung in der Frequenz herabteilenden Frequenzteiler, d a d u r c h g e k e n n z e i c h n e t, dass mit dem in der Frequenz herabgeteilten Ausgangssignal (S, T, U) des Frequenzteilers (2) ein elektronischer Analog-Schalter (3) gesteuert ist, mit dem unmittelbar aus der Ursprungsschwingung (0) die in der Frequenz niedrigere Ausgangsschwingung (A) mit der Kurvenform der Ursprungsschwingung ausgeblendet wird.

2. Schaltungsanordnung nach Anspruch 1, d a d u r c h g e k e n n z e i c h n e t, dass der Beginn (13) der Ausblendimpulse (U) für den elektronischen Schalter (3) durch einen Phasenschieber (7) an die Phase der Ursprungsschwingung (0) angepasst ist.

3. Schaltungsanordnung nach Anspruch 1 oder 2, d a - d u r c h g e k e n n z e i c h n e t, daß das Ende (14) der Ausblendimpulse (U) für den elektronischen Schalter (3) durch eine logische Schaltung (4) bestimmt ist, die von dem geteilten Ausgangssignal (T) des Frequenzteilers (2) und einem um die Periodendauer (2x) der Ursprungsschwingung (0) in der Phase verschobenen Signal (S) gleicher Frequenz angesteuert ist.

4. Schaltungsanordnung nach Anspruch 2 oder 3, d a - d u r c h   g e k e n n z e i c h n e t, dass der Phasenschieber (7) zwischen der logischen Schaltung (4) und dem elektronischen Schalter (3) angeordnet ist.

5. Schaltungsanordnung nach einem oder mehreren der vorhergehenden Ansprüche, d a d u r c h   g e k e n n - z e i c h n e t, dass der elektronische Schalter (3) durch die eine Steuerstrecke (g2, d) eines Doppelgate-Feldeffekttransistors (11) gebildet ist, dessen andere Steuerstrecke (g1, s) von den Ausblendimpulsen (U) angesteuert ist.

6. Schaltungsanordnung nach einem oder mehreren der vorhergehenden Ansprüche, d a d u r c h   g e k e n n - z e i c h n e t, dass zwischen elektronischem Schalter (3) und Ausgang (12) eine die durch Ausblenden erzeugte Ausgangsschwingung (A) auf ein Tastverhältnis von 1:1 umformende Halteschaltung (8) vorgesehen ist.

0026442

0026442

## EUROPÄISCHER RECHERCHENBERICHT

Europäisches Patentamt

Nummer der Anmeldung

EP 80 10 5730.8

| | EINSCHLÄGIGE DOKUMENTE | | KLASSIFIKATION DER ANMELDUNG (Int.Cl.3) |
|---|---|---|---|
| Kategorie | Kennzeichnung des Dokuments mit Angabe, soweit erforderlich, der maßgeblichen Teile | betrifft Anspruch | |
| X | US - A - 3 737 676 (J.C. FLETCHER et al.) <br> * Fig. 1 bis 7 * | 1,2, 5 | H 03 B 1/04 <br> H 03 K 21/00. |
| | DE - A1 - 2 608 413 (SIEMENS) <br> * Seite 4, Zeile 3 und ff.; Fig. 1 bis 3 * | 1 | |
| A | DE - B-2 055 226 (WANDEL U. GOLTERMANN) <br> * Fig. 1 bis 4 * | | RECHERCHIERTE SACHGEBIETE (Int. Cl.3) |
| A | DE - A - 2 420 003 (GENERAL ELECTRIC) <br> * Fig. 1 bis 5 * | | H 03 B 1/00 <br> H 03 K 21/00 |
| A | US - A - 3 581 213 (E.E. CRUMP) <br> * Fig. 1 bis 3 * | | |
| A | US - A -3 517 213 (R.H. BRITTON, JR.) <br> * Fig. 1 und 2 * | | |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 02-01-1981 | BREUSING |

EPA form 1503.1 06.78